# EUROPEAN PATENT APPLICATION

(11) **EP 1 069 173 A1**
(43) Date of publication of application: **17.01.2001**
(21) Application number: 00305670.2
(22) Date of filing: 05.07.2000
(51) Int. Cl.: C09K 21/02, C09D 5/18, D06M 11/82

(54) **Non-inflammable matter**

(30) Priority: 05.07.1999 GB 9915630
(71) Applicant: Shafaei, Manoochehr, Iffley, Oxford OX4 4DS (GB)
(72) Inventor: Shafaei, Manoochehr, Iffley, Oxford OX4 4DS (GB)
(74) Representative: Marlow, Nicholas Simon

(57) **Abstract**

Compositions comprising boric acid, borax and ammonium nitrate for reducing the inflammability of a substrate are described. Methods for treating a substrate to reduce its inflammability are also described.

## Description

The present invention relates to compositions for reducing the inflammability of a substrate and to methods for treating the substrate to reduce its inflammability.

Fire and its discovery was a God-given-gift and played an enormous role in the progress and evolution of the human communities. Nevertheless, despite its vital role, the flame of fire has caused considerable personal injury, financial loss and environmental damage to human communities each year.

Inflammable substrates are hazardous because they are prone to catch fire. Consequently it has been desired to provide an effective way of making these inflammable substrates less hazardous.

According to the invention there is provided a composition for reducing the inflammability of a substrate which comprises boric acid, borax and ammonium nitrate.

Compositions according to the invention may further comprise water. The components of compositions according to the invention may be in aqueous solution.

Preferably boric acid is present in compositions according to the invention from about 2% to about 6%, more preferably from about 2% to about 4.5%, by weight of the composition.

Preferably borax is present in compositions according to the invention from about 3% to about 8%, more preferably from about 3% to about 6%, by weight of the composition.

Preferably ammonium nitrate is present in compositions according to the invention upto about 3%, more preferably from about 1% to about 3%, most preferably from about 1% to about 2%, by weight of the composition.

The preferred amount of boric acid, borax or ammonium nitrate in compositions according to the invention may vary depending on the substrate of which the inflammability is to be reduced.

According to the invention there is also provided a method for reducing the inflammability of a substrate which comprises contacting a composition according to the invention with the substrate.

The efficacy of aqueous solutions of compositions according to the invention in decreasing the inflammability of a substrate has been found to be increased if each component of the composition is separately dissolved, at least partially, to form the aqueous solution. This may be done by sequentially dissolving, at least partially, each component of a composition of the invention in the same aliquot of water to form the aqueous solution. The components may be dissolved in any order. Preferably each component is substantially completely dissolved before the next is added. Alternatively, each component may be dissolved, at least partially, in a separate aliquot of water and then the separate aliquots combined to form the aqueous solution. Preferably each component is substantially completely dissolved in the separate aliquots before they are combined.

The length of time for which a substrate is contacted with a composition according to the invention in order to decrease its inflammability may be reduced if the substrate is contacted with the composition at a temperature above room temperature, preferably between 50°C and 90°C. Alternatively, the degree to which the inflammability of the substrate is reduced may be increased by contacting the composition with the substrate at a temperature above room temperature, preferably between 50°C and 90°C. These effects may be achieved, for example, by immersing the substrate in an aqueous solution of a composition according to the invention at 50°C to 90°C.

Compositions according to the invention have the following advantages:

The components of the compositions of the invention present no danger to the environment.

Smoke and gases ascending therefrom during heating and combustion are not poisonous and do not cause pollution.

Substrates soaked in compositions of the invention do not suffer from premature decay or quality weakness.

The compositions of the invention do not cause any skin or internal disease in humans (even if ingested). They do not cause any poisoning or allergy and do not have any other bad effects.

Other advantages are that the components of the compositions of the invention are easily obtainable and affordable, the production method is simple, and the production rate is high.

With minor modification to the formula, the compositions of the invention are capable of reducing the inflammability of different industrial products (such as wood, paper or textile).

Substrates can readily be treated to reduce their inflammability by simply contacting the substrates with a composition of the invention.

Compositions of the invention do not leave any visible mark on substrates which have been treated according to the invention.

It is possible to present the compositions of the invention in the form of a spray which has a temporary non-inflammable effect, and can be rubbed or washed off.

The quality of a substrate treated with a composition of the invention remains unaltered and is not adversely affected.

A further advantage of the compositions of the invention is that they can be used in different industries and that their effect can be permanent.

With textiles, the non-inflammable effect will be destroyed by complete washing. However, dry cleaning of textiles treated according to the invention does not destroy the non-inflammable effect of the treatment.

Compositions of the invention may be used together with a waterproofing agent. Substrates treated with a composition of the invention mixed with a waterproofing agent have been found to have reduced inflammability and water resistance.

Embodiments of the invention will now be described in detail, by way of example only, with reference to the accompanying drawings in which:
Figure 1 shows schematically a system for producing an aqueous solution of a composition of the invention; and
Figure 2 shows schematically an alternative system for producing an aqueous solution of a composition of the invention.

Preferred methods for making compositions according to the invention and treating substrates with such compositions to reduce their inflammability are described below:
The components of a composition of the invention are stored separately;
Water at 50°C to 90°C is added to a mixer;
The components of the composition are weighed separately and dissolved sequentially in the water in the mixer. Each component is substantially completely dissolved before the next is added;
Once a composition according to the invention has been prepared, it can be stored, for example, in a concrete chamber or in barrels made from stainless steel or plastic.

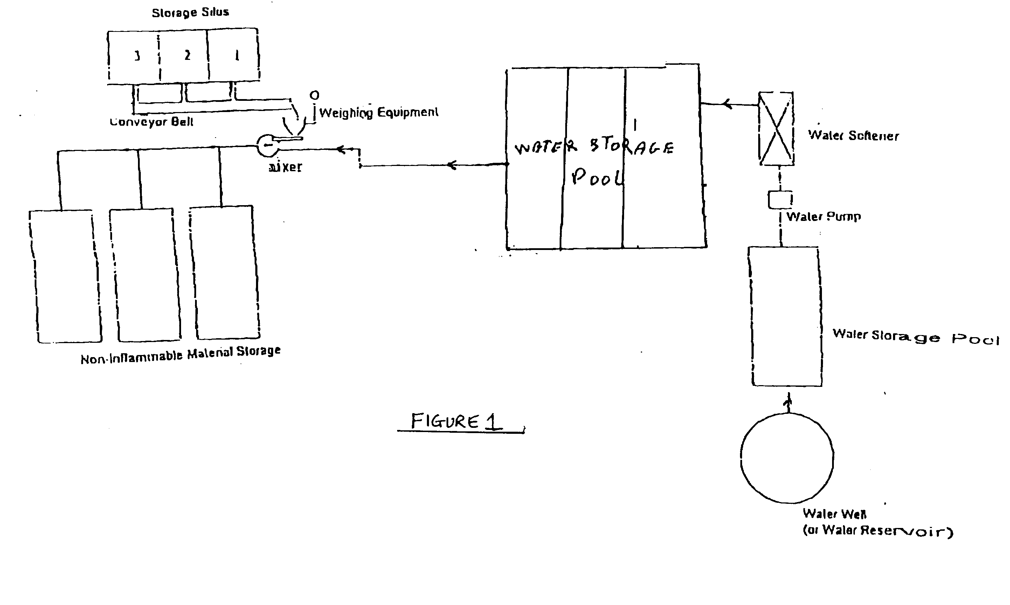

Figure 1 shows:
A) Supply of Water
   1. Supply and storage of water (for example from a well or reservoir).
   2. Softening of water using a water softener.
   3. Storage of water before it is added to a mixer.
B) Supply of Material
   1. Storage of up to three components of a composition of the invention in separate storage chambers.
   2. Transport of the components of the composition from the storage chambers by a conveyor belt to be weighed separately.
   3. Transport of the components to the mixer after they have been weighed.
C) Method of Production in Mixer
   1. Addition of water to the mixer at approximately 50°C to 90°C.
   2. Entry of the components of the composition to the mixer. The components are weighed and added to the mixer sequentially. After one component has been substantially dissolved in the water, the next is added.
   3. Removal of a prepared composition of the invention from the mixer.
   4. Storage of the prepared composition.

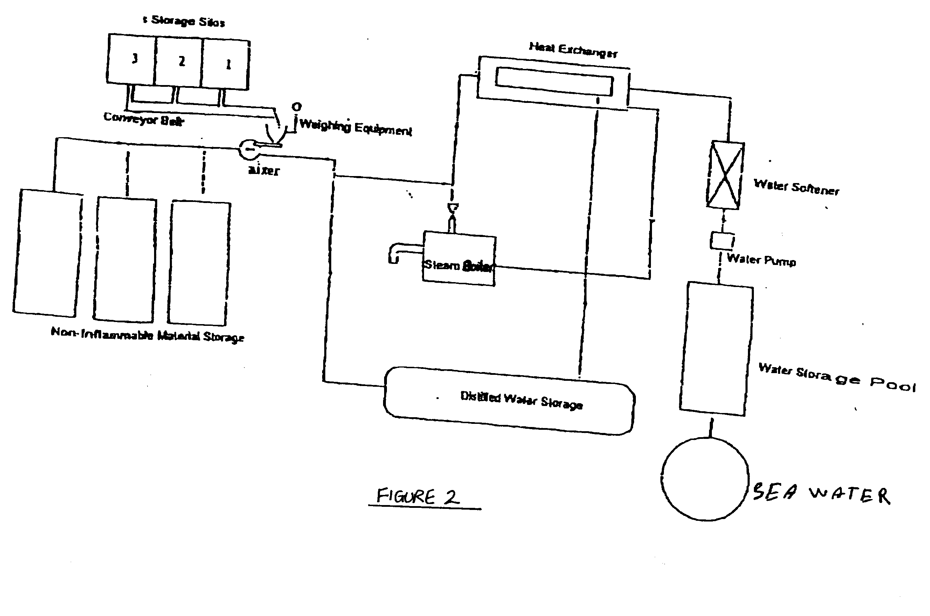

Sea water can be used as a source of the water for dissolving the components of compositions of the invention if the sea water is first distilled. Figure 2 shows schematically a system for producing an aqueous solution of a composition of the invention using sea water as the source of the water.
A) Supply of water
   1. Supply and storage of sea water.
   2. Softening of sea water using a water softener.
   3. Distilling of softened sea water using a heat exchanger.
   4. Distilled water from the heat exchanger can either be added directly to the mixer or stored before it is added to the mixer.

The supply of material to the mixer and the method of production in the mixer are similar to that described for Figure 1.

In the Examples described below, the inflammability of each substrate was found to have decreased after being soaked in the specified composition according to the invention for a total of 5 to 15 minutes.

The treatment of substrates with the compositions of the invention may take place at an appropriate stage in the manufacture of the substrate, depending on the substrate. All products of the industries described below may be treated with an aqueous solution of a composition of the invention after their manufacture is complete and/or during the manufacture process. In the case of tarpaulin, treatment may be before the drying process, and after painting. In the case of fibre, treatment may be at the time of preparation of the fibre mix. In the case of printed circuit boards and in paper or textile manufacture, treatment may be at the beginning of the production process.

### Use of Compositions of the Invention in Different Industries

### Example 1

### The Wood Industry

Preferred compositions according to the invention for use in the wood industry comprise 3% to 6% boric acid, 4% to 8% borax and 0.5% to 2% ammonium nitrate, by weight of the composition, and water. Examples of methods for treating wood are:
i) Wood Veneering Industry
   Conventionally, tree trunks are soaked in water to prepare them for cutting. Aqueous solutions of compositions according to the invention may be used instead of water. Such aqueous solutions penetrate the wood of the tree trunks. The inflammability of veneer prepared from the tree trunks is thereby reduced.
ii) Chipboard Industry
   Conventionally, wood chips are mixed with resin, then compressed and dried in a furnace to form chipboard. The wood used to prepare the wood chips, the wood chips themselves, or the compressed wood chip/resin mixture may be treated with an aqueous solution of a composition of the invention and dried before continuing with the next stage of the chipboard manufacture process. The inflammability of the chipboard thereby produced is reduced. Alternatively or additionally, the finished chipboard may be treated with an aqueous solution of a composition of the invention.
iii) The Fibreboard Industry
   Conventionally, a wood fibre mix is prepared and then compressed to form fibreboard. The inflammability of fibreboard may be reduced if the wood used to make the fibre mix, or the fibre mix itself, is treated with an aqueous solution of a composition of the invention. Alternatively or additionally the finished fibreboard may be treated with an aqueous solution of a composition of the invention.
iv) The Plywood Industry
   Conventionally, layers of wood are cut, glued and pressed together with the grain of adjacent layers running in different directions. The inflammability of plywood may be reduced by treating the wood used to make the plywood with an aqueous solution of a composition of the invention before or after it has been cut. Alternatively or additionally, the finished plywood may be treated with an aqueous solution of a composition of the invention.
v) The Panel Industry
   The inflammability of wood used to make panels may be reduced by treating the wood with an aqueous solution of a composition of the invention before or after it has been cut. Alternatively or additionally, the finished panels may be treated with an aqueous solution of a composition of the invention.

### Example 2

### The Textile Industry

i) The inflammability of different types of soft and delicate textiles (for example, textiles for use as furniture covering, curtains, or normal fabric) can be reduced by treating the textile with an aqueous solution of a composition of the invention. Preferred compositions according to the invention for treating such textiles comprise 2 to 4% boric acid, 3 to 5% borax, 1% ammonium nitrate, by weight of the composition, and water.
ii) The inflammability of thicker textiles (such as tarpaulin and sackcloth) may be reduced by treating the textile with an aqueous solution of a composition of the invention.

Preferred compositions according to the invention for treating such textiles comprise 2 to 4% boric acid, 3 to 5% borax, 1 to 2% ammonium nitrate, by weight of the composition, and water.

### Example 3

### The Paper Industry

i) The inflammability of paper (such as conventional writing paper, melamine coated paper, wall paper, cardboard, and other similar papers) may be reduced by treating it with an aqueous solution of a composition of the invention. The inflammability of paper may also be reduced by treating the fibres used to make the paper with an aqueous solution of a composition of the invention before they are pressed together.

Preferred compositions according to the invention for treating paper comprise 2 to 4% boric acid, 3 to 5% borax, 1% ammonium nitrate, by weight of the composition, and water.

### Example 4

### The Electronics Industry

i) The inflammability of printed circuit boards made from textile and resin may be reduced by treating the textile use to make the circuit boards with an aqueous solution of a composition of the invention.
   Preferred compositions according to the invention for treating textiles used for making printed circuit boards comprise 2 to 4% boric acid, 3 to 4.5% borax, 1 to 2% ammonium nitrate, by weight of the composition, and water.
ii) The inflammability of electrical isolators made from paper and resin may be reduced by treating the paper used to make the isolators with an aqueous solution of a composition of the invention.
   Preferred compositions according to the invention for treating paper used to make electrical isolators comprise 2 to 4% boric acid, 3 to 5% borax, 1% ammonium nitrate, by weight of the composition, and water.

### Example 5

### The Paint Industry

The inflammability of paint suitable for painting plastics may be reduced by mixing the powdered components used to make the paint with an aqueous solution of a composition of the invention and then adding the remaining components of the paint.

Preferred compositions according to the invention for reducing the inflammability of such paint comprise 2 to 4% boric acid, 3 to 5% borax, 1% ammonium nitrate, by weight of the composition, and water.

Compositions and methods of the invention provide a simple and effective way of reducing the inflammability of a wide variety of substrates. We proudly declare that we have saved the human race from one of the calamities.

## Claims

1. A composition for reducing the inflammability of a substrate, the composition comprising boric acid, borax and ammonium nitrate.

2. A composition according to claim 1 in which the boric acid is present at about 2% to about 6%, preferably about 2% to about 4.5%, by weight of the composition.

3. A composition according to claim 1 or 2 in which the borax is present at about 3% to about 8%, preferably about 3% to about 6%, by weight of the composition.

4. A composition according to any preceding claim in which the ammonium nitrate is present upto about 3%, preferably at about 1% to about 3%, more preferably at about 1% to about 2%, by weight of the composition.

5. A composition according to any preceding claim in aqueous solution.

6. A method for making a composition according to claim 5 which comprises sequentially dissolving, at least partially, each component of the composition to form the aqueous solution.

7. A method for making a composition according to claim 5 which comprises dissolving, at least partially, each component of the composition in a separate aliquot of water and then combining the separate aliquots to form the aqueous solution.

8. A method for reducing the inflammability of a substrate which comprises contacting a composition according to any of claims 1 to 4 with the substrate.

9. A method according to claim 8 in which the composition is in aqueous solution.

10. A method according to claim 9 which further comprises making the composition using a method according to claim 6 or 7.

11. A method according to any of claims 8 to 10 in which the composition is contacted with the substrate at a temperature above room temperature, preferably between 50°C and 90°C.

12. Use of a composition according to any of claims 1 to 5 for reducing the inflammability of a substrate.
